**Europäisches Patentamt**

(19) **European Patent Office**

**Office européen des brevets**

(11) Numéro de publication: **0 073 309**
**B1**

(12) # FASCICULE DE BREVET EUROPEEN

(45) Date de publication du fascicule du brevet:
31.07.85

(51) Int. Cl.⁴: **H 04 N 7/13, H 04 B 14/06**

(21) Numéro de dépôt: **82105354.3**

(22) Date de dépôt: **01.02.79**

(60) Numéro de publication de la demande initiale en application de l'article 76 CBE:

(54) Compression et expansion (quantification) de signaux numériques de télévision à codage différentiel.

(30) Priorité: **08.12.78 FR 7835485**

(43) Date de publication de la demande:
**09.03.83 Bulletin 83/10**

(45) Mention de la délivrance du brevet:
**31.07.85 Bulletin 85/31**

(84) Etats contractants désignés:
**BE CH DE GB IT NL SE**

(56) Documents cités:
**DE - A - 2 124 060**
**DE - A - 2 643 761**

**INSTITUTE OF ELECTRICAL AND ELECTRONICS ENGINEERS, NTC record '72; National Telecommunications conference; 4-6 décembre 1972, Houston Texas, 1972, IEEE, pages 27E-1-27E-6, New York (USA); H.G. MUSMANN: "Source encoding with fixed word length and synchronous bit rate"**

(73) Titulaire: **Etablissement Public de Diffusion dit "Télédiffusion de France", 21-27 rue Barbès, F-92120 Montrouge (FR)**
Titulaire: **Kretz, Francis, 5, rue de la Croix-Connue, F-35510 Cesson-Sevigne (FR)**
Titulaire: **Boudeville, Jean-Louis, 6, rue de la Cotinière, F-35500 Vitre (FR)**

(72) Inventeur: **Kretz, Francis, 5, rue de la Croix-Connue, F-35510 Cesson-Sévigné (FR)**
Inventeur: **Boudeville, Jean-Louis, 6, rue de la Cotinière, F-35500 Vitré (FR)**

(74) Mandataire: **Le Guen, Louis François, Cabinet Louis Le Guen 1, avenue Edouard VII B.P. 91, F-35802 Dinard Cédex (FR)**

BUNDESDRUCKEREI BERLIN

## Description

La présente invention résulte d'une division de la demande de brevet européen 0 012 632.

On rappelle que, dans le codage MICD simple, antérieur au brevet DE 2 643 761 et à la demande EP 0 012 632, on codait la différence $d_n$ entre la valeur $X_n$ d'un échantillon du signal de télévision à coder et une estimation de cette valeur calculée à partir d'échantillons codés voisins antérieurs. Chaque valeur de différence $d_n$ est située dans une zone de codage délimitée par deux seuils et est codée selon une combinaison codée prédéterminée $C_n$ associée à la zone de codage. Cette combinaison codée $C_n$ est ensuite traduite tant au codeur qu'au décodeur en une valeur de la différence appelée niveau de reconstruction $\hat{d}_n$. Les zones de codage et les niveaux de reconstruction sont serrés près de la valeur 0 de $d_n$ et s'écartent progressivement pour les différences de plus grande amplitude. Les zones et les niveaux de reconstruction étaient répartis symétriquement par rapport à la valeur 0.

Dans les documents DE 2 643 761 et EP 0 012 632, on a prévu une caractéristique de quantification qui est, au moins partiellement, non symétrique par rapport à zéro, en ce qui concerne le nombre et les valeurs des seuils et des niveaux de reconstruction. De plus, dans le document EP 0 012 632, cette caractéristique de quantification comprend, dans ses parties non symétriques, moins de niveaux pour la région des différences négatives que pour celle des différences positives, quand le signal de télévision à coder est à convention positive, (ou l'inverse dans le cas contraire), et les valeurs des niveaux extrêmes négatifs de reconstruction sont sensiblement moins négatives que les points milieux des segments correspondants définis par les degrés de quantification.

Ces résultats correspondaient notamment des conséquences tirées par les demandeurs du document EP 0 012 632 de certaines propriétés des images de télévision et de l'observateur humain du point de vue de sa perception de la qualité subjective.

La poursuite de l'exploitation de ces résultats, avec pour objet l'amélioration de la qualité des images, a conduit à considérer la variation de ces propriétés des images et de l'observateur humain en fonction de l'estimation, c'est à dire de la valeur de la prédiction $P_n$ concernant le point à coder.

Comme l'indique l'article technique intitulé »Source encoding with fixed word length and synchronous bit rate« par H. G. Musmann et paru dans les compte-rendus »IEEE CHO 601-5 National Television Conference Record« de 1972, pp. 27E-1 — 27E-6, on a déjà proposé de faire varier la caractéristique de quantification suivant la valeur de prédiction $P_n$ concernant le point à coder.

Suivant une caractéristique de la présente invention, il est prévu une caractéristique de quantification, qui est définie par le nombre et les valeurs des seuils et des niveaux de reconstruction et qui varie suivant la valeur de la prédiction $P_n$ concernant le point à coder, la gamme de variation de la prédiction $P_n$ étant découpée en zones de prédiction $Z_i$, i variant de 1 à k, à chaque zone de prédiction $Z_i$ étant associée une caractéristique de quantification $Q_i$, qui est invariante pour toutes les valeurs $X_n$ de l'échantillon à coder dont la valeur de prédiction $P_n$ est incluse dans la zone $Z_i$, mais variant d'une zone $Z_i$ à une autre, chaque caractéristique de quantification $Q_i$, comportant le même nombre N de valeurs de seuils et de niveaux de reconstruction, mais des niveaux extrêmes négatifs différents d'une d'une zone de prédiction $Z_i$ à une autre, dans laquelle les zone de prédiction $Z_i$ ne sont pas symétriques par rapport à la mi-dynamique de la prédiction $P_n$.

Suivant une autre caractéristique, les caractéristiques de quantification $Q_i$ (seuils et niveaux) sont non symétriques les unes des autres par rapport au point correspondant à la mi-dynamique de $P_n$.

Suivant une autre caractéristique, les caractéristiques de quantification $Q_i$ sont des segments d'une caractéristique de quantification $Q'$, laquelle comporte un nombre de niveau N' plus important que N.

Suivant une autre caractéristique, la caractéristique de quantification étendue $Q'$ est dissymétrique, au sens des documents DE 2 643 761 ou EP 0 012 632.

Par ailleurs, il faut bien comprendre que, dans le décodeur qui reçoit les signaux codés, on effectue le même calcul de prédiction que dans le codeur. Donc, on n'a pas d'information supplémentaire à transmettre du codeur au décodeur pour indiquer à ce dernier le numéro de la zone de prédiction $Z_i$ pour chaque point.

Les caractéristiques de l'invention mentionnée ci-dessus, ainsi que d'autres, apparaîtront plus clairement à la lecture de la description suivante d'exemples de réalisation mettant en œuvre la quantification suivant l'invention, ladite description étant faite en relation avec les dessins joints, parmi lesquels:

la Fig. 1a est un diagramme illustrant une méthode de codage suivant l'invention,

la Fig. 1b est un diagramme illustrant une variante de méthode de codage suivant l'invention,

la Fig. 2 est un bloc-diagramme d'un circuit de codeur fonctionnant suivant la méthode de codage illustrée à la Fig. 1b,

la Fig. 3 est un bloc-diagramme d'une variante du circuit de la Fig. 1, qui fonctionne également suivant la méthode de codage illustrée à la Fig. 1b,

la Fig. 4 est un bloc-diagramme d'un circuit de décodeur capable de décoder des signaux codés provenant du codeur de la Fig. 2 ou de celui de la Fig. 3,

la Fig. 5 est un bloc-diagramme d'un circuit de codeur fonctionnant suivant la méthode de codage illustrée à la Fig. 1a,

2

la Fig. 6 est un bloc-diagramme d'une variante du circuit de la Fig. 5, qui fonctionne également suivant la méthode de codage illustrée à la Fig. 1a, et

la Fig. 7 est un bloc-diagramme d'un circuit de décodeur capable de décodeur des signaux codés provenant du codeur de la Fig. 5 ou de celui de la Fig. 6.

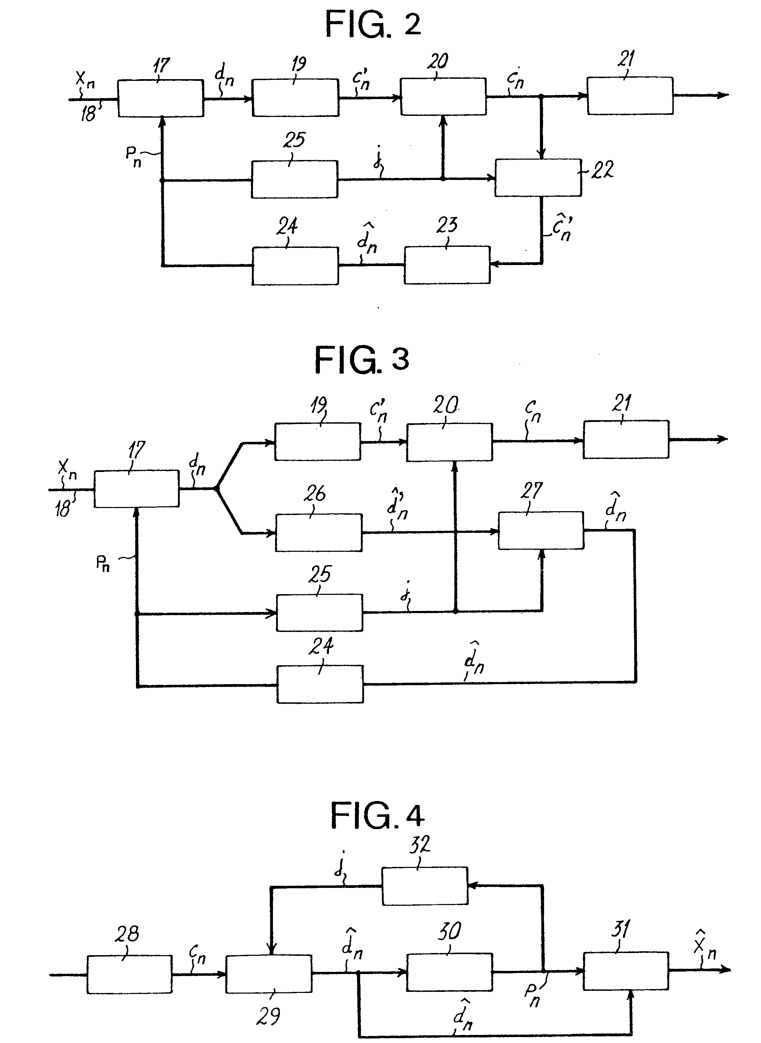

Ou pourra utilement se reporter à la Fig. 3 de la demande de brevet EP 0 012 632 dans laquelle on a représenté une caractéristique de quantification formée de segments horizontaux tracés dans un système de coordonnées avec en abscisse les valeurs des seuils de $d_n$ et en ordonnée les valeurs de reconstruction $\hat{d}_n$, les valeurs des seuils déterminant consécutivement deux à deux les extrémités des segments et les valeurs de reconstruction des hauteurs des segments, les numéros des segments correspondent aux codes $C_n$. Il apparaît clairement à la Fig. 3 de la demande de brevet EP 0 012 632 que l'allure de la courbe formée par les segments est dissymétrique par rapport à l'origine, ce qui correspond à la dissymétrie de la caractéristique de quantification. On notera encore que $d_n$ est supposé varier entre $-255$ et $+255$.

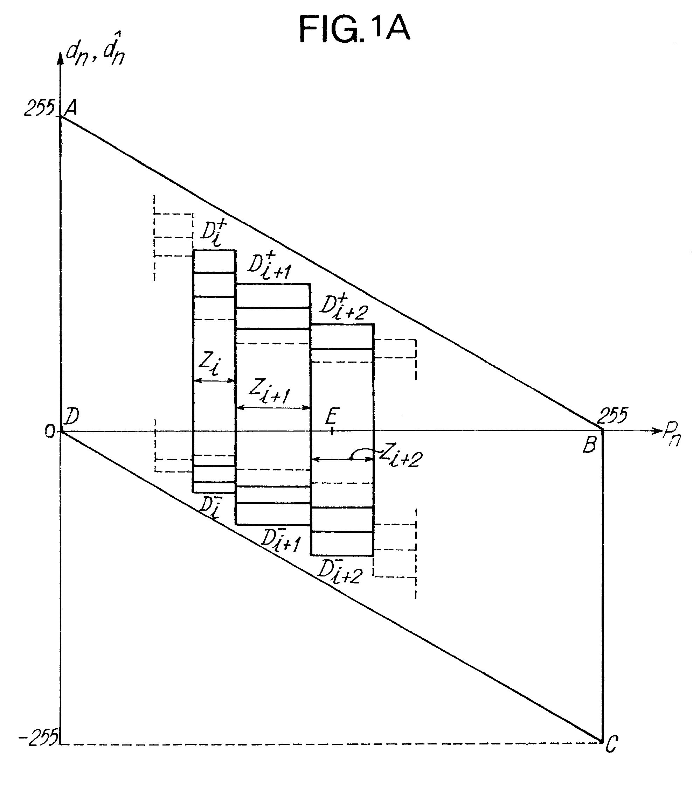

A la Fig. 1a, on a représenté des zones de prédiction $Z_i$ dans un système de coordonnées avec en abscisse $P_n$, valeur de prédiction, et en ordonnée $d_n$, et donc $\hat{d}_n$. On suppose que $P_n$ peut prendre une valeur quelconque entre 0 et 255, ce qui correspond à un codage MIC à 8 éléments binaires. Donc $d_n$ et $\hat{d}_n$ peuvent prendre des valeurs comprises entre $-255$ et $+255$, en cas de convention positive, comme on l'a défini dans la demande EP 0 012 632.

Dans la méthode illustrée à la Fig. 1a, les zones des codage $C_n$ sont fonctions à la fois de $d_n$ et de $P_n$, tandis que les niveaux de reconstruction $\hat{d}_n$ sont également fonctions de $C_n$ et de $P_n$, avec la simplification suivante: dans chaque zone de prédiction $Z_i$, i variant de 1 à k, la caractéristique de quantification est invariante, ce qui se traduit par les formules:

$$C_n = f(d_n, i) \text{ et } \hat{d}_n = g(C_n, i)$$

si $P_n$ est dans la zone de prédiction $Z_i$.

Il apparaît que les zones $Z_i$ à $Z_k$ juxtaposées recouvrent l'axe DB du parallélogramme ABCD, dont les côtés représentent les limites théoriques de l'erreur de prédiction $d_n = X_n - P_n$ en fonction de $P_n$. En pratique, ces limites ne sont jamais atteintes et les valeurs de $d_n$, dans chaque zone $Z_i$, peuvent être limitées à des valeurs inférieures en valeur absolue, telles que $D_i^+$ et $D_i^-$. Comme le montre la Fig. 1a, les zones $Z_i$ sont de largeur variable et les niveaux extrêmes $D_i^+$ et $D_i^-$ sont également variables. On notera également variables. On notera également que les différents niveaux de reconstruction et seuils dans les zones ne coïncident pas d'une zone à la zone adjacente. De plus, de préférence, les zones $Z_i$ ne sont pas symétriques par rapport au point E se trouvant sur l'axe des abscisses au milieu de DB et marquant la mi-dynamique de P. Même si les zones sont symétriques par rapport à E, les caractéristiques de quantification $Q_i$ (seuils et niveaux) ne sont pas symétriques les unes des autres par rapport à E.

Dans chaque zone $Z_i$, on prévoit N niveaux, y compris $D_i^+$ et $D_i^-$, qui ne sont pas symétriques par rapport au point dont l'ordonnée est nulle ($d_n = 0$), mais de préférence sont distribués d'une manière analogue à la distribution des 16 niveaux de la Fig. 3 de la demande EP 0 012 632, N peut être égal à 16 ce qui correspond pour les codes $C_n^i$ à des mots de 4 bits.

A la Fig. 1a, on a notamment montré trois zones $Z_i$, $Z_{i+1}$ et $Z_{i+2}$, dont les dargeurs sont manifestement différentes, ceci simplement à titre d'exemple.

Dans la pratique, les largeurs et la distribution, des zones $Z_i$, suivant l'axe des abscisses, les valeurs de $D_i^+$ et $D_i^-$ et les caractéristiques de quantification $Q_i$ sont déterminées par l'expérience et choisies à la suite d'essais subjectifs.

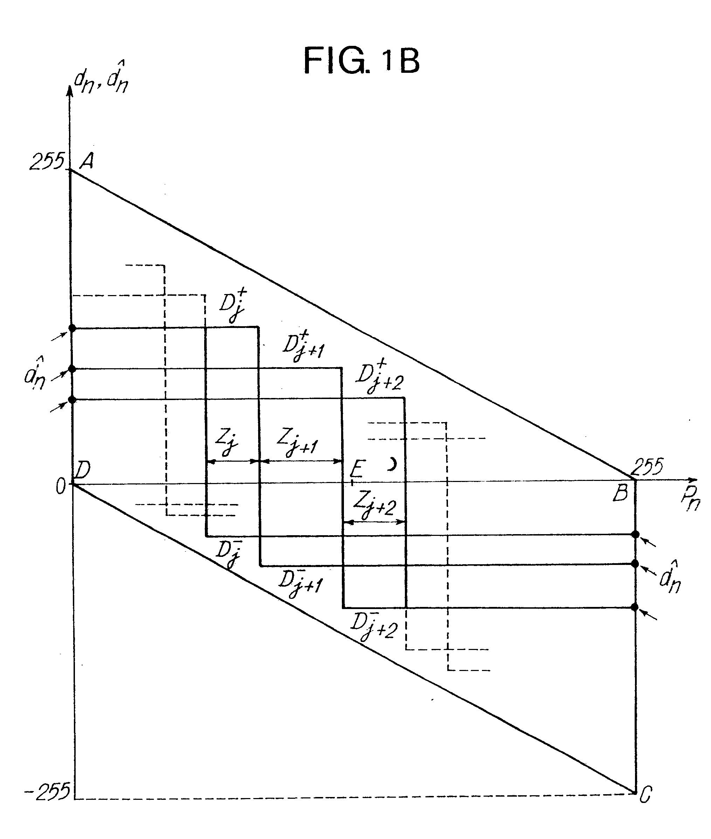

A la Fig. 1b, on a encore représenté des zones de prédiction $Z_j$ dans un parallèlogramme ABCD identique à celui de la Fig. 1a. Comme les zones $Z_i$, les zones $Z_j$ sont adjacentes, ont des largeurs différentes, sont distribuées non symétriquement par rapport au point E et couvrent la plus grande partie du rectangle ABCD. Par contre, elles en sont différentes en ce qui concerne la distribution des seuils. En effet, les N seuils de chaque charactéristique de quantification de chaque zone $Z_j$ sont pris parmi les N' seuils d'une même caractéristique de quantification étendue, N', étant nettement plus grand que N, les N seuils pris dans la caractéristique étendue pour former N seuils d'une zone $Z_j$ étant consécutifs. Il en résulte évidemment que les niveaux de reconstruction extrêmes $D_j^+$ et $D_j^-$ d'une zone $Z_j$ correspondent à des niveaux de la caractéristique de quantification étendue séparée par N-2 niveaux.

Ainsi, dans le cas illustré à la Fig. 1b, les niveaux de reconstruction et les zones de codage constituent une caractéristique de quantification $Q_j$ partielle de la caractéristique de quantification étendue Q'. Cette méthode de codage MICD à zones de prédiction consiste donc à ramener sur les niveaux de saturation $D_j^+$ et $D_j^-$ (propres à la zone de prédiction), chaque zone $Z_j$, les niveaux de reconstruction d'une caractéristique de quantification étendue Q' qui leur sont extériéurs et à supprimer les zones de codage associées à ces niveaux masqués.

La caractéristique de quantification étendue Q' est définie à la suite d'essais subjectifs, ainsi que les zones $Z_j$ et les niveaux de saturation $D_j^-$ et $D_j^+$. La qualité de l'image obtenue avec le codage à zones de prédiction de la Fig. 1b est normalement voisine de celle qui serait fournie par le codage MICD à quantificateur unique défini par la caractéristique Q'. L'avantage est bien entendu qu'à qualité pratiquement égale, le codage à zones de prédiction n'a besoin que de N mots de code pour assurer la transmission au lieu de N'. Ainsi, si on choisit, par exemple, N égal à 16 et N' de l'ordre de 32, il apparaît que la présente invention présente un avantage important par rapport à la méthode utilisée dans le brevet EP 0 012 632 en permettant avec des mots transmis de même longueur d'obtenir une qualité d'image nettement supérieure, puisque tout se passe comme si le nombre des niveau était double.

Comme dans la demande EP 0 012 632, on choisit pour la caractéristique de quantification étendue Q' de préférence une forme dissymétrique. De plus, les zones de prédiction $Z_j$ sont choisies non symétriques par rapport au point E. Comme la caractéristique Q' n'est pas symétrique, l'ensemble des valeurs de saturation positive $D_j^+$ n'est pas symétrique de l'ensemble des valeurs de saturation négative $D_j^-$ par rapport à E.

Toutefois. on peut prévoir une méthode légèrement sous-optimale en utilisant une caractéristique de quantification étendue symétrique, mais dans laquelle ni les zones de prédiction $Z_j$, ni les ensembles de valeurs de saturation positive et négative ne sont symétriques par rapport au point E.

Tableau I

Valeurs des seuils, des codes et des niveaux de reconstruction de la caractéristique de quantification étendue.

| Valeurs de $d_n$ (seuils) | Codes $C'_n$ | Niveau de reconstruction $\hat{d}_n$ |
|---|---|---|
| $-255$ à $-231$ | 1 | $-245$ |
| $-230$ à $-202$ | 2 | $-215$ |
| $-201$ à $-176$ | 3 | $-188$ |
| $-175$ à $-153$ | 4 | $-163$ |
| $-152$ à $-131$ | 5 | $-141$ |
| $-130$ à $-110$ | 6 | $-119$ |
| $-109$ à $-91$ | 7 | $-99$ |
| $-90$ à $-74$ | 8 | $-81$ |
| $-73$ à $-58$ | 9 | $-65$ |
| $-57$ à $-44$ | 10 | $-50$ |
| $-43$ à $-32$ | 11 | $-37$ |
| $-31$ à $-20$ | 12 | $-25$ |
| $-19$ à $-11$ | 13 | $-14$ |
| $-10$ à $-4$ | 14 | $-6$ |
| $-3$ à $-1$ | 15 | $-2$ |
| 0 | 16 | 0 |
| 1 à 3 | 17 | 2 |
| 4 à 10 | 18 | 6 |
| 11 à 19 | 19 | 14 |
| 20 à 31 | 20 | 25 |

**0 073 309**

Tableau I (Suite)

| Valeurs de $d_n$ (seuils) | Codes $C'_n$ | Niveau de reconstruction $\hat{d}_n$ |
|---|---|---|
| 32 à 43 | 21 | 37 |
| 44 à 57 | 22 | 50 |
| 58 à 73 | 23 | 65 |
| 74 à 90 | 24 | 81 |
| 91 à 109 | 25 | 99 |
| 110 à 130 | 26 | 119 |
| 131 à 152 | 27 | 141 |
| 153 à 175 | 28 | 163 |
| 176 à 201 | 29 | 188 |
| 202 à 230 | 30 | 215 |
| 231 à 255 | 31 | 245 |

Tableau II

Limites des zones de prédiction, numéro des zones et niveau de saturation positive et négative

| Valeurs de $P_n$ (limites des zones) | numéro de zone | Niveau de saturation positive | Niveau de saturation négative |
|---|---|---|---|
| 0 à 1 | 1 | 245 | 0 |
| 2 à 9 | 2 | 215 | − 2 |
| 10 à 29 | 3 | 188 | − 6 |
| 24 à 49 | 4 | 163 | − 14 |
| 50 à 73 | 5 | 141 | − 25 |
| 74 à 95 | 6 | 119 | − 37 |
| 96 à 112 | 7 | 99 | − 50 |
| 113 à 132 | 8 | 81 | − 65 |
| 133 à 148 | 9 | 65 | − 81 |
| 149 à 165 | 10 | 50 | − 99 |
| 166 à 192 | 11 | 37 | −119 |
| 193 à 220 | 12 | 25 | −141 |
| 221 à 241 | 13 | 14 | −163 |
| 242 à 249 | 14 | 6 | −188 |
| 250 à 253 | 15 | 2 | −215 |
| 254 à 255 | 16 | 0 | −245 |

**0 073 309**

Les tableaux I et II ci-après donnent les valeurs numériques d'un exemple de mise en œuvre d'une telle méthode légèrement sousoptimale. La caractéristique de quantification étendue est définie dans le tableau I. Elle comporte 31 codes $C'_n$. Les zones de prédiction et les valeurs de saturation sont définies dans le tableau II. Le débit numérique est, dans cet exemple de 4 bits par point, avec pour objectif un codage de signaux de télévision à 34 Mbit/s. On a pu, au cours d'essais, observer que la qualité subjective de l'image présentée est meilleure que celle que l'on peut obtenir avec une caractè-ristique de quantification à 16 niveaux, comme dans le brevet EP 0 012 632, sans masquage, selon la zone de prédiction. L'examen des tableaux I et II fait encore ressortir qu'il a été rajouté, près des valeurs extrêmes 0 et 255 de $P_n$, des zones de prédiction telles que les valeurs de saturation $D_i$ et $D_i$ ' soient toujours dans le parallèlogramme ABCD, quelle que soit la valeur de $P_n$. Ce procédé permet d'éliminer la correction de débordement nécessaire classiquement dans le calcul de prédiction. Il faut noter que le même pocédé peut être utilisé dans la méthode illustrée dans la Fig. 1a.

Un exemple de réalisation d'un codeur à caractéristique étendue fonctionnant suivant la méthode illustrée à la Fig. 1b, est montré à la Fig. 2. Ce codeur comprend un soustracteur algébrique 17 dont la première entrée est reliée à l'entrée de signal 18 à laquelle est appliquée le signal de télévision à coder, et dont la sortie est reliée à l'entrée d'un circuit quantificateur 19. La sortie du circuit 19 est reliée à l'entrée d'un transcodeur-réducteur 20 dont la sortie est, d'une part, reliée à un circuit d'utilisation 21, tel que par exemple un organe de transmission, et, d'autre part, reliée à un transcodeur 22, inverse du transcodeur 20. La sortie du transcodeur 22 est reliée à l'entrée d'un convertisseur 23 dont la sortie est reliée à l'entrée d'un circuit prédicteur 24 dont la sortie est reliée à la seconde entrée du soustracteur 17. La sortie du prédicteur 24 est également reliée à l'entrée d'un codeur de zone de prédiction 25 dont la sortie est reliée, d'une part, à l'entrée de commande du transcodeur 20 et, d'autre part, à l'entrée de commande du transcodeur 22.

Dans l'exemple de réalisation décrit, on suppose que le signal d'image de télévision appliqué à l'entrée 18 se trouve sous forme numérique $X_n$ et est délivré par un codeur classique MIC, non montré. Le soustracteur 17 effectue la différence $d_n$ entre le signal numérique $X_n$ et un signal numérique de prédiction $P_n$ délivré par le prédicteur 24. Le circuit quantificateur 19 peut être constitué par une mémoire morte de codage dans laquelle les valeurs $d_n$ sont considérées comme des adresses auxquelles correspondent des signaux numériques $C'_n$ en nombre k' suivant la caractéristique de quantification étendue Q'. Si la caractéristique étendue correspond au tableau Ia, on a 31 signaux $C'_n$ possi-bles. Par ailleurs, le codeur 25 délivre en fonction de la valeur du signal numérique $P_n$ un signal numérique i, lequel définit, comme on l'a décrit ci-dessus, des valeurs extrêmes de codes $C'_n$, c'est à dire les valeurs $C_i^-$ et $C_i^+$. Quand le signal $C'_n$ délivré par 19 est compris entre $C_i^-$ et $C_i^+$, il peut être simplement transmis à la sortie du transcodeur 20 un signal de différence de niveaux égal à $(C'_n - C_i^-)$. Quand $C'_n < C_i^-$, le transcodeur 20 délivre un signal de valeur 0 et quand $C'_n > C_i^+$, il délivre un signal de valeur k, k étant égal dans l'exemple décrit à 15. On a indiqué que le transcodeur 20 délivre les codes $C_n$ correspondant à ces valeurs, lesquels sont lus pour être appliqués au circuit 21 qui les transmet.

Par ailleurs, les signaux numériques $C_n$ sont également appliqués au convertisseur 22 dont l'entrée de commande reçoit également la valeur i. Le convertisseur 22 effectue l'opération inverse de celle qu'a effectuée le transcodeur 20, c'est à dire dans l'exemple pris ci-dessus, qu'il ajoute au signal $C_n$ reçu de 20 la valeur $C_i^-$, afin de délivrer un signal $\hat{C}'_n$. Il faut noter que si la valeur de $\hat{C}'_n$ tombait dans l'intervalle $C_i$, $C_i$ défini dans 20 par la valeur i délivrée par 25, la valeur $C_n$ délivrée par 22 est identique à $C'_n$, car le transcodeur inverse 22 reçoit le même signal i de 25.

Les signaux numériques $\hat{C}'_n$ sont appliqués au convertisseur 23, lequel peut être constitué par une mémoire de décodage dans laquelle les valeurs $\hat{C}'_n$ sont considérées comme des adresses auxquelles correspondent des signaux numériques qui constituent classiquement les différences reconstruites. Le circuit prédicteur 24, qui peut être classique comme le circuit 6 de la demande EP 0 012 632, délivre pour chaque point le signal numérique de prédiction $P_n$.

Ce signal $P_n$ est bien entendu appliqué classiquement à la seconde entrée du soustracteur 17, mais également à l'entrée du codeur 25, lequel peut être un simple discriminateur de niveaux de signaux numériques. Si l'on considère l'exemple des valeurs donnés dans le tableau II, il apparaît qu'à une valeur de $P_n$ comprise entre 0 et 255 correspond un numéro de zone i compris entre 1 et 16, inclus. Le codeur 25 peut être une mémoire de décodage très simple, comme 19 et 23.

Le codeur de la Fig. 3 constitue une variante de celui de la Fig. 2 et comprend également les circuits 17, 19, 21, 24 et 25 fonctionnant comme dans le codeur de la Fig. 2. Les circuits 22 et 23 sont remplacés par deux circuits 26 et 27. Le circuit 26 a son entrée de signal reliée à la sortie de 17 et sa sortie de signal reliée à l'entrée de signal du circuit 27 dont la sortie est reliée à l'entrée du prédicteur 24. L'entrée de commande du circuit 27 est reliée à la sortie du codeur de zone 25. Le circuit 26 est un codeur qui délivre, en fonction du signal numérique $d_n$ qui lui est appliqué, un autre signal numérique $\hat{d}'_n$ en suivant une table de correspondance qui, par exemple, peut être celle du tableau I. En pratique, le circuit 26 peut être une mémoire morte dans laquelle aux adresses $d_n$ sont enregistrées directement les valeurs numériques des signaux $\hat{d}'_n$. Le circuit 27 est un limiteur qui limite les valeurs $\hat{d}'_n$ aux valeurs extrêmes positives $D_i$ ' et négatives $D_i$ définies en fonction de i d'après le tableau I, et qui donc délivre un signal numérique $\hat{d}_n$, identique à celui délivré par 23 à la Fig. 2. En pratique, le circuit 27 peut

6

aussi être une mémoire morte contenant les valeurs $D_i{}^+$ et $D_i{}^-$, associée à deux compateurs logiques.

Le décodeur MICD de la Fig. 4 est prévu pour recevoir des signaux codés, suivant la méthode illustrée à la Fig. 1b, c'est à dire des signaux émis par le codeur de la Fig. 2 ou celui de la Fig. 3. Il comprend un organe de réception 28 qui reçoit les signaux numériques transmis par l'organe de transmission 21 des Figs. 1 et 3 qui délivre les signaux $C_n$ reçus à un circuit convertisseur 29. La sortie du convertisseur 29 est reliée, d'une part, à un circuit prédicteur 30 et, d'autre part, à la première entrée d'un additionneur algébrique 31. La sortie du prédicteur 30 est reliée à la seconde entrée de l'additionneur 31, d'une part, et à l'entrée d'un codeur de zone 32, d'autre part. La sortie du codeur 32 est reliée à l'entrée de commande du convertisseur 29. En pratique, le circuit 29 comporte en série un circuit 22 et un circuit 23 de la Fig. 2 si bien que, comme 23, le circuit 29 délivre le même signal $\hat{d}_n$ que 23. En conséquence, le prédicteur 30 qui est identique au prédicteur 24, délivre le même signal $P_n$ qui est appliqué au codeur 32 qui, identique à 25, délivre le même code i indiquant la zone de prédiction. Il apparaît donc clairement qu'effectuant les mêmes opérations numériques dans le codeur et le décodeur, on n'a pas à transmettre en lignes d'autres informations que $C_n$. Bien entendu, à chaque début de ligne d'image de télévision et éventuellement au début de chaque image quand le prédicteur est bidimensionnel, le codeur et le décodeur sont placés par des moyens propres dans les mêmes conditions initiales.

Enfin, l'additionneur 31 fait la somme de $P_n$ et de $\hat{d}_n$ ce qui, classiquement, donne la valeur reconstruite $\hat{X}_n$, laquelle est, après une conversion numérique-analogique, appliquée à un récepteur de télévision non montré.

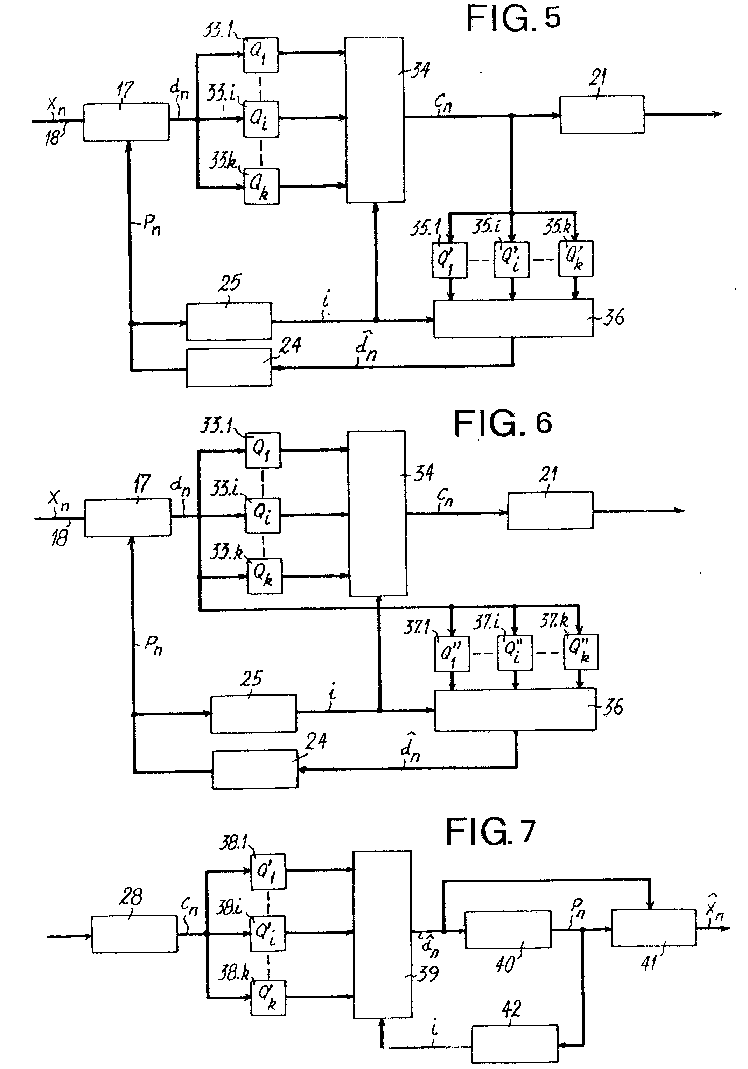

Un exemple de réalisation d'un codeur à commutation de caractéristiques de quantification, fonctionnant suivant la méthode illustrée à la Fig. 1a, est montré à la Fig. 5. Ce codeur comprend un soustracteur algébrique 17 dont une entrée reçoit le signal $X_n$ et l'autre le signal prédit $P_n$. La sortie de 17 est reliée en parallèle aux entrées de quantificateurs 33.1 à 33.k ayant respectivement les caractéristiques de quantifications $Q_1$ à $Q_k$. Les sorties des quantificateurs 33.1 à 33.k sont respectivement reliées aux entrées d'un sélecteur 34 dont la sortie est reliée, d'une part, à un organe de transmission 21 et, d'autre part, en parallèle aux entrées de convertisseurs 35.1 à 35.k. Les sorties des convertisseurs 35.1 à 35.k sont respectivement reliées aux entrées d'un sélecteur 36 dont la sortie est reliée à l'entrée du prédicteur 24. La sortie du codeur est reliée, en parallèle, aux entrées de commande des sélecteurs 34 et 36.

Chaque quantificateur 33.i a sa propre caractéristique $Q_i$, c'est à dire qu'en fonction de $d_n$ il applique à l'entrée correspondante de 34 un signal $C_n^i$. Le sélecteur 34 commandé par la sortie de 25 choisit un des signaux d'entrée pour le délivrer et il constitue alors le signal $C_n$, comme à la Fig.2. Par ailleurs, tous les convertisseurs 35.1 à 35.k recevant le signal $C_n$ délivrent, en fonction de leurs caractéristiques inverses $Q'_1$ à $Q'_k$, les signaux $\hat{d}_n^i$ et le sélecteur 36, commandé par la sortie de 25, choisit la sortie de rang i pour la transmettre, ce qui donne $\hat{d}_n$.

Le codeur de la Fig. 6 est une variante de celui de la Fig. 5. On y retrouve les circuits 17, 33.1 à 33.k, 34, 21, 24, 25 et 36, mais les convertisseurs 37.1 à 37.k y remplacent les convertisseurs 35.1 à 35.k et ont leurs entrées respectives reliées en parallèle à la sortie du soustracteur 17. Ainsi, comme dans le codeur de la Fig. 4, le signal $d_n$ est directement, suivant un tableau analogue au tableau I, converti en signaux $\hat{d}_n^i$. Le fonctionnement des sélecteurs 34 et 36 est le même que précédemment.

En fait, cette méthode de codage illustrée à la Fig. 1a, consiste à disposer d'autant de caractéristiques de quantification différentes ($Q_i - Q'_i$ qu'il y a de zones de prédiction. Chacune possède le même nombre N de codes, comme dans les codeurs des Figs. 2 et 3, on n'a qu'une simple variante technique de la méthode de fonctionnement des codeurs des Figs. 2 et 3. Par contre, si les N codes sont adaptés à chaque zone de prédiction, indépendamment de ceux des autres zones, il est possible de suivre de plus près les résultats expérimentaux et d'obtenir ainsi une qualité légèrement supérieure pour un même nombre de codes.

La Fig. 7 montre un décodeur capable de recevoir les signaux transmis à partir de l'orange 21 des Figs. 5 et 6. Il comprend un organe de réception 28 dont la sortie est reliée, en parallèle, aux entrées de convertisseurs 38.1 à 38.k, identiques aux convertisseurs 35.1 à 35.k, dont les sorties sont reliées aux entrées d'un sélecteur 39, identique à 36. La sortie de 39 est reliée, d'une part, à l'entrée d'un prédicteur 40, identique à 24 et, d'autre part, à une entrée d'un additionneur 41. La sortie du prédicteur 40 est reliée, d'une part, à la seconde entrée de l'additionneur 41 et, d'autre part, à l'entrée d'un codeur de zone 42, identique à 25, dont la sortie est reliée à l'entrée de commande du sélecteur 39.

L'organe 28 délivre les signaux $C_n$. Comme 36, le sélecteur 39 délivre les signaux $\hat{d}_n$. Le prédicteur 40 délivre les signaux $P_n$ et donc le circuit 42 délivre le même code i que 25. L'additionneur 41 délivre le signal $\hat{X}_n$ qui est converti avant d'être appliqué à un téléviseur.

**Revendications**

1. Procédé de compression et expansion (quantification) de signaux numériques de télévision à codage différentiel MICD, dans lequel les valeurs des degrés et des niveaux de reconstruction varient suivant la valeur de prédiction $P_n$ concernant le point courant à coder, la gamme de variation de la

valeur de prédicition $P_n$ étant découpée en zone de prédiction $Z_i$, i variant de 1 à k, à chaque zone de prédiction $Z_i$ étant associé un ensemble de valeurs de degrés et de niveaux de reconstruction $Q_i$, qui est invariant pour toutes les valeurs $X_n$ de l'échantillon à coder dont la valeur de prédiction $P_n$ est incluse dans la zone $Z_i$, mais variant d'une zone $Z_i$ à une autre, chaque ensemble $Q_i$ comportant le même nombre N de valeurs de degrés et de niveaux de reconstruktion, avec des valeurs de degrés et de niveaux extrêmes négatives et positives différentes d'une zone de prédiction $Z_i$ à une autre, caractérisé en ce que les zones de prédiction $Z_i$ ne sont pas symétriques par rapport à la moyenne dynamique de la valeur de prédiction $P_n$.

2. Procédé suivant la revendication 1, caractérisé en ce que les ensembles $Q_i$ font partie d'un ensemble étendu $Q'$ de degrés et de valeurs de reconstruction en nombre $N'$ plus grand que N, l'ensemble étendu $Q'$ étant un ensemble suivant la revendication 1.

3. Procédé suivant la revendication 1 ou 2, caractérisé en ce que les ensembles $Q_i$ sont non symétriques les uns des autres par rapport au point correspondant à la mi-dynamique de $P_n$.

## Patentansprüche

1. Ein Verfahren zur Kompression und Expansion (Quantifikation) von DPCM digitalen differenzkodierten Fernsehsignalen, bei dem die Werte der Schwellen und der Rekonstruktionspegel sich entsprechend dem Voraussagewert $P_n$ relativ zu dem laufenden zu kodierenden Punkt ändert, wobei der Änderungsbereich des Voraussagewertes $P_n$ in Voraussagezonen $Z_i$ unterteilt wird, worin i sich von 1 bis k ändert, wobei jeder Voraussagezone eine Gruppe von Werten der Schwellen und Rekonstruktionspegel $Q_i$ zugeordnet ist, wobei die genannte Gruppe für alle Werte $X_n$ der zu kodierenden Probe unveränderlich ist, deren Voraussagewert $P_n$ in der Zone $Z_i$ enthalten ist, die sich aber von einer Zone $Z_i$ zu einer anderen ändert, wobei jede Gruppe $Q_i$ die gleiche Zahl N von Werten von Schwellen und Rekonstruktionspegeln hat, mit negativen und positiven Extremwerten von Schwellen und Rekonstruktionspegeln, die von einer Voraussagezone $Z_i$ zu einer anderen verschieden sind, dadurch gekennzeichnet, daß die Voraussagezonen $Z_i$ nicht symmetrisch in bezug auf den dynamischen Durchschnitt des Voraussagewertes $P_n$ sind.

2. Ein Verfahren nach Anspruch 1, dadurch gekennzeichnet, daß die Gruppen $Q_i$ Teil einer vergrößerten Gruppe $Q'$ von Schwellen und Rekonstruktionswerten sind, deren Zahl $N'$ größer als N ist, wobei die vergrößerte Gruppe $Q'$ eine Gruppe gemäß Anspruch 1 ist.

3. Ein Verfahren nach Anspruch 1 oder 2, dadurch gekennzeichnet, daß die Gruppen $Q_i$ nicht symmetrisch zueinander in bezug auf den Punkt sind, der der Halbdynamik von $P_n$ entspricht.

## Claims

1. A process of compression and expansion (quantification) of DPCM digital differentially encoded television signals, wherein the values of the thresholds and reconstruction levels are varying according to the prediction value $P_n$ relative to the currant point to be encoded, the range of variation of the predicition value $P_n$ being divided into prediction zones $Z_i$ where i varies from 1 to k, a set of values of thresholds and reconstruction levels $Q_i$ being associated with each prediction zone $Z_i$, said set being invariable for all values $X_n$ of the sample to be encoded, the prediction value $P_n$ of which is included in the zone $Z_i$, said set varying from a zone $Z_i$ to another, each set $Q_i$ having the same number N of values of thresholds and reconstruction levels, with negative and positive extreme values of thresholds and reconstruction levels which are different from one prediction zone $Z_i$ to another, characterized in that the prediction zones $Z_i$ are nonsymmetrical with respect to the dynamic average of the prediction value $P_n$.

2. A process according to claim 1, characterized in that the sets $Q_i$ are segments of an enlarged set $Q'$ of thresholds and reconstruction values, the number $N'$ of which is more important than N, the enlarged set $Q'$ being a set according to claim 1.

3. A process according to claim 1 or 2, characterized in that the sets $Q_i$ are non-symmetrical with each other with respect to the point corresponding to the half-dynamics of $P_n$.

# FIG.1A

# FIG. 1B

# FIG. 2

# FIG. 3

# FIG. 4

13

# FIG. 5

# FIG. 6

# FIG. 7

15